# EUROPÄISCHE PATENTSCHRIFT

(11) **EP 0 606 936 B1**
(45) Veröffentlichungstag und Bekanntmachung des Hinweises auf die Patenterteilung: **25.09.1996**
(21) Anmeldenummer: 94200019.1
(22) Anmeldetag: 06.01.1994
(51) Int. Cl.: H05K 7/14, B60R 11/02

(54) **Einrichtung zum lösbaren Befestigen eines elektrischen Servicegerätes**
Device for detachably attaching an electrical service apparatus
Dispositif pour attacher d'une façon amovible un appareil électrique de service

(30) Priorität: 14.01.1993 DE 4300734
(43) Veröffentlichungstag der Anmeldung: 20.07.1994
(73) Patentinhaber: Philips Patentverwaltung GmbH, 22335 Hamburg (DE); Philips Electronics N.V., 5621 BA Eindhoven (NL)
(72) Erfinder: Kühl, Peter, D-20097 Hamburg (DE); Lünter, Heinz, D-20097 Hamburg (DE); Rinneburger, Klaus, D-20097 Hamburg (DE); Rückert, Manfred, D-91469 Hagenbüchach (DE)
(74) Vertreter: von Laue, Hanns-Ulrich, Dipl.-Ing.

(56) Entgegenhaltungen:
- WO-A-86/02891
- DE-U- 8 911 712
- FR-A- 2 447 299

## Beschreibung

Die Erfindung bezieht sich auf eine Einrichtung zum lösbaren Befestigen eines elektrischen Servicegerätes, wie eines Autoradios, CD- oder Kassettenspielers, Verstärkers, Verkehrsleitgerätes und dergl., in einem Einschubausschnitt eines Einbauteiles, das die Armaturentafel eines Fahrzeuges sein kann, mit am Gerät angeordneten Gegenstützen, die in der eine Hintergreifstellung bildende Einbaulage, in der das Gerät von vorn in den Einbauausschnitt angeschoben ist, das Einbauteil von hinten hintergreifen und die zur Freigabe des Gerätes aus der Hintergreifstellung in eine Freigabestellung überführbar sind.

Einrichtungen zum lösbaren Befestigen von elektrischen Servicegeräten sind an sich bekannt. Eine derartige Einrichtung ist in der DE 29 03 176 C2 beschrieben. Die Gegenstützen bestehen dabei aus biegsam ausgebildeten Zungen, deren freie Enden, wenn das Gerät in den Einschubausschnitt der Einbauwand eingeschoben ist und mit seinem Frontteil an der Vorderseite der Einbauwand anliegt, rückwärtig eine Gegenstütze bilden. Die Zungenenden haben dazu eine nach außen gerichtete Federvorspannung und sind bestrebt, in der Einbauwand einzurasten. Durch das Ausfedern zur Seite bilden die Federenden damit die Gegenstütze, die bewirkt, daß das Gerät im Einbauausschnitt der Einbauplatte festgelegt ist.

Zum Lösen der Gegenstütze bildenden Federzungen dienen Stifte, die bei ihrem Einschieben die ausgefederten Federenden so gegeneinander drücken, daß diese in eine Freigabestellung im Bereich des Einbauausschnittes überführt sind.

Die Befestigung der Federzungen und deren Anordnung benötigt Platz, der bei immer enger werdendem Raum nur noch schwer bereitstellbar ist.

Es ist Aufgabe der Erfindung, eine Einrichtung der eingangs erwähnten Art zu schaffen, die einerseits kleinbauend ist, andererseits aber auch störende Löcher in der Frontplatte für die einzuschiebenden Stifte überflüssig macht.

Die gestellte Aufgabe ist erfindungsgemäß dadurch gelöst, daß die Gegenstütze aus einer um eine Drehachse schwenkbaren Klinke besteht, die in Richtung auf die Hintergreifstellung von einer Feder belastet ist und die eine Stellkurve aufweist, gegen die ein Entrasthebel schiebbar ist, der beim Entlanglaufen an der Stellkurve die Klinke gegen die Federkraft in die Freigabestellung verschwenkt.

Bei einem derartigen Aufbau ist es möglich, zwischen zwei Tasten in der Frontplatte des Gerätes hindurch zu der Befestigungseinrichtung zu gelangen. Die Befestigungseinrichtung selbst ist nur eine relativ kleine schwenkbare Klinke, die in einer Ecke hinter der Frontplatte Platz findet.

Nach einer weiteren Ausgestaltung der Erfindung ist vorgesehen, daß an das in Einschieberichtung gelegene Ende der Stellkurve an einer Mulde endet, in die der die Stellkurve abfahrende Entrastschlüssel einfallen kann, um darin zu verrasten. Der Schlüssel verrastet sich damit also, um einerseits das Herausziehen des Servicegerätes aus der Einbauwand zu ermöglichen und andererseits ein unbewußtes Verlieren des Schlüssels zu vermeiden.

Nach einer weiteren Ausgestaltung der Erfindung ist vorgesehen, daß die Klinke eine Rastnase und der Entrastschlüssel eine Sicherheitsöffnung für das Eintauchen der Entrastnase in die Sicherheitsöffnung aufweist, wobei die Entrastnase und die Sicherheitsöffnung so zusammenwirken, daß der Entrastschlüssel von der eintauchenden Rastnase gegen ein Herausziehen gesichert ist, bis die Klinke in die Hintergreifstellung fällt. Die Rastnase mit der Sicherungsöffnung zusammen sorgen dafür, daß erst nach einem Überhub der Klinke ein Lösen des Schlüssels möglich ist.

Nach einer weiteren Ausgestaltung der Erfindung ist vorgesehen, daß an der Klinke ein Betätigungshebel vorgesehen ist, der auf einen Sicherheitscodierschalter einwirkt, der bereits beim Verschwenken der Klinke in die Sicherheitskodierstellung für die Elektronik des Gerätes überführbar ist. Auf diese Weise kann die Sicherheitscodierung im Augenblick der Klinkenverschwenkung aktiviert werden. Der bisher vorhandene Zeitraum zwischen dem Entladen der Kondensatoren und der Aktivierung der Sicherheitscodierung entfällt damit.

Nach einer weiteren Ausgestaltung der Erfindung ist vorgesehen, daß die Feder eine getrennte Stahlfeder ist, die sich in einem Lagerauge der Klinke und in einem Gegenlager abstützt.

Die Erfindung wird anhand der Zeichnung näher erläutert. Es zeigen:
Fig. 1 die Einrichtung nach der Erfindung in der Ruhe- oder Einbaulage, in der eine Klinke eine Einbauwand hintergreift und damit das Servicegerät zwischen Vorderseite und Hinterseite der Einbauwand einklemmt,
Fig. 2 die Einrichtung mit in die Entraststellung geschwenkter Klinke, in der das Gerät aus einem Einschubeinschnitt der Einbauwand herausgezogen werden kann,
Fig. 3 einen Entrastschlüssel in Draufsicht,
Fig. 4 die Einrichtung bei mit Überhub verschwenkter Klinke, um den Entrastschlüssel aus dem Gerät herausziehen zu können,
Fig. 5 die Einrichtung mit abgewandelter Schlüsselform bei mit Überhub verschwenkter Klinke.

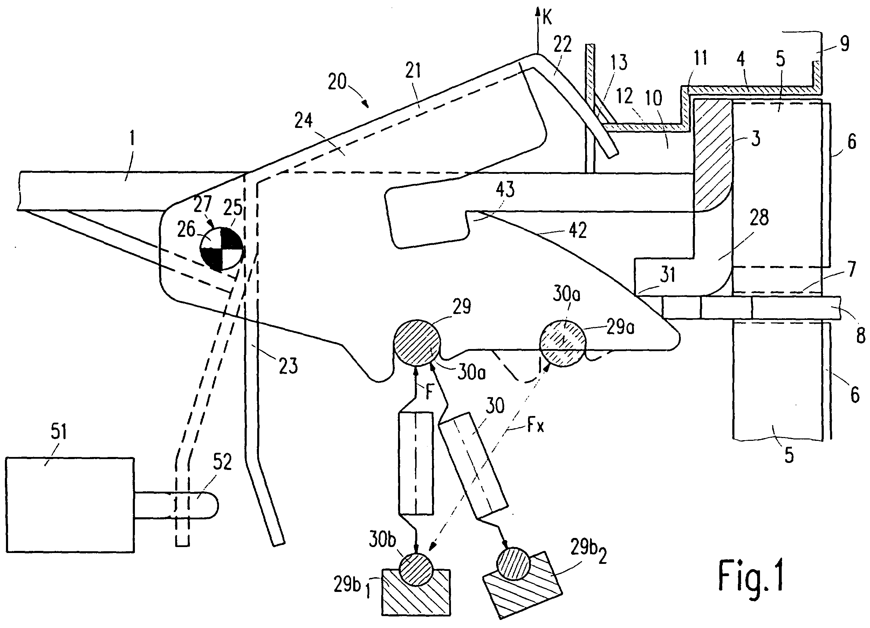

Fig. 1 zeigt eine Seitenwand 1 eines elektrischen Servicegerätes, wie eines Autoradios, eines CD-Spielers, eines Verstärkers, eines Verkehrsleitgerätes oder dergl.. Die Vorderkante 3 der Gehäuseseitenwand befindet sich am oder im Bereich des vorn gelegenen Frontteiles 4 des Gerätes. In dem Frontteil sind Öffnungen 5 für nach vorn weisende Funktionstasten 6 vorgesehen. Zwischen den Öffnungen 5 und den Funktionstasten 6 verbleibt ein Schlitz 7, in den ein Entrastschlüssel 8 einsetzbar ist.

In einer Einbauwand 9, beispielsweise der Armaturentafel eines Kraftfahrzeuges, ist ein Einschuböffnung 10 vorgesehen, in die das Servicegerät einschiebbar ist. Ist das Servicegeräte in die Einbauwand eingeschoben, dann liegt es mit seiner Vorderkante 3 gegen einen Absatz 11 der Einschuböffnungswand 12 an.

Es ist eine Einrichtung zum lösbaren Befestigen des Servicegerätes in der Einbauwand 9 vorgesehen, mit der das Servicegerät in dem Einschubausschnitt festlegbar ist. Die Einrichtung besteht aus einer Klinke 20, die ein Blechformteil ist. Die Klinke 20 kann aber auch ein Kunststoffspritzteil sein; sie besteht aus einem Rücken 21, der an der Klinkenvorderseite in einer Rastnase 22 und an der Klinkenrückseite in einem Betätigungshebel 23 ausläuft. Beiderseits des Rückens 21 befinden sich etwa rechtwinklig von ihm abgebogene Flankenplatten 24, die parallel zueinander verlaufen. Die Flankenplatten 24 sind mit Lageröffnungen 24 versehen, durch die Lagerbolzen 26 der Seitenwand 1 hindurchgreifen. Auf diese Weise entsteht ein Drehlager 27, um das die Klinke 20 verschwenkbar ist.

Die Flankenplatten 24 sind mit Lageraugen 29 versehen, in die eine Klinkenfeder 30 mit einem Federende 30a eingreift. Die Klinkenfeder 30 übt auf die Klinke 20 eine Kraft in Richtung eines Pfeiles F aus, welche bestrebt ist, die Klinke in die aus Fig. 1 zu erkennende Lage zu verschwenken. Die Schwenkbewegung der Klinke 20 wird dabei begrenzt durch einen Lagerpunkt 31 des Widerlagers 28.

Die Wirkrichtung der Feder und die Plazierung des Lagerauges können den Verhältnissen angepaßt sein. So kann das Lagerauge 29a (gestrichelt) weiter von dem Drehlager 27 entfernt vorgesehen werden, um den Drehhebel zu verlängern. Ebenso können Gegenlager 29b₁ und 29b₂ der Klinkenfeder 30 an verschiedenen Stellen vorgesehen sein, um so den Einfluß der Klinkenfeder 30 auf den Klinkenhebel 20 zu verändern. So kann die Klinkenfeder 30 beispielsweise auch eine Kraft Fx auf das Lagerauge 29a ausüben, wenn sich das eine Federende 30a im Lagerauge 29a befindet und das andere Federende 30b im Gegenlager 29b₁ abstützt.

Aus Fig. 1 ist zu ersehen, daß die Rastnase 22 dabei gegen die Einschuböffnungswand drückt. In dieser Hintergreifstellung nach Fig. 1 verklemmt die Klinke 20 das Servicegerät in der Einbauwand zwischen dem Absatz 11 und einer Andruckkante 13 der Einschuböffnungswand 12. Das Servicegerät ist also in der Einbauwand 9 sicher festgelegt. Die Andruckkraft K läßt sich variieren durch die Lage des Lagerauges 29 gegenüber dem Lager 27. Durch die Wahl der Lage des Lagerauges 29 läßt sich der Kräfteverlauf und die Andruckkraft K an der Andruckkante 13 linear ansteigend, progressiv ansteigend oder nahezu konstant wählen.

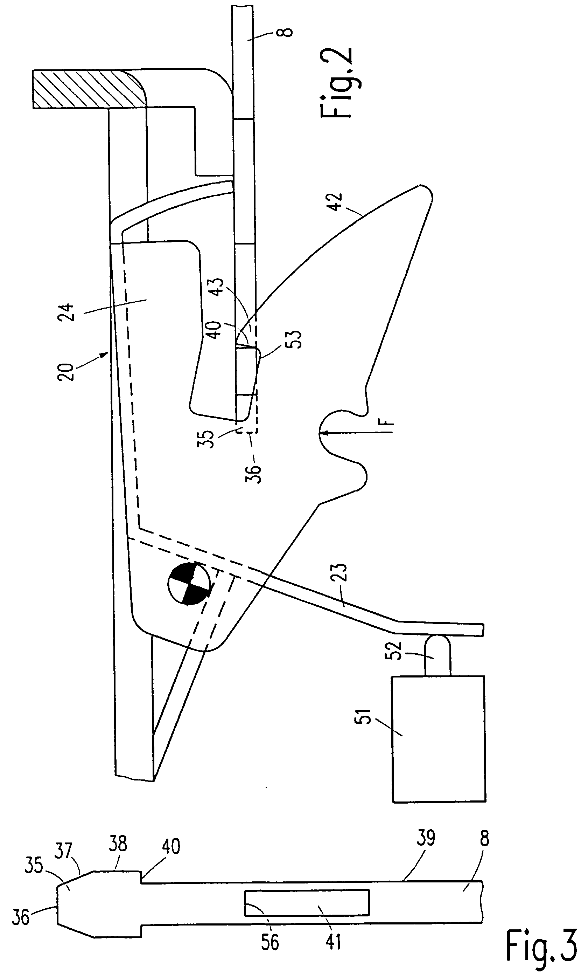

Um das Servicegerät aus der Einbauwand 9 herausziehen zu können, muß die Klinke im Uhrzeigersinn verschwenkt werden. Dies erfolgt mit Hilfe des Entrastschlüssels 8. Das Gerät ist mit zwei Klinken 20 versehen, und zwar je einer Klinke an der rechten und linken Seitenwand 1. Dementsprechend befinden sich auch im Frontteil jeweils rechts und links zwischen den Tasten 6 die nahezu unsichtbaren Schlitze 7, in die jeweils ein Entrastschlüssel eingeschoben wird. Da die Entrastfunktion und die Entrastmechanismen an beiden Geräteseiten gleich sind, genügt die Beschreibung nur einer Klinke 20 im Zusammenwirken mit einem Entrastschlüssel 8. Zur Verdeutlichung der Funktion und des Schlüssels ist dieser in Fig. 3 in Draufsicht dargestellt, während er in Fig. 2 in seiner Funktion in Seitendarstellung wiedergegeben ist. Der Entrastschlüssel 8 hat einen Schlüsselkopf 35, der von seiner Vorderkante 36 über Leitflächen 37 in einen Rastteil 38 übergeht. Zwischen dem Schlüsselschaft 39 und dem breiter ausgebildeten Rastteil 38 bildet sich eine Rastkante 40 aus. Im Schlüsselschaft 39 befindet sich noch eine Überhuböffnung 41.

Wird der Entrastschlüssel 8 in den Schlitz 7 eingeschoben, dann stößt der Schlüsselkopf 35 mit den Leitflächen 37 gegen Stellkurven 42 der Klinke 20. Die Stellkurven 42 sind bogenförmig ausgebildet und stellen Linearisierungskurven dar, die die Schwenkbewegung der Klinke 20 regeln, und zwar derart, daß die Entrastkräfte in bestimmten Grenzen linearisiert werden, um ein starkes Ansteigen der Kräfte zu vermeiden. Bei einer geradlinigen Führung der Stellkurve 42 würden die Entrastkräfte relativ stark ansteigen.

Wird der Entrastschlüssel 8, wie in Fig. 1 dargestellt, gegen die Stellkurve 42 geschoben, dann gleiten die Leitflächen an beiden Flankenstücken 24 an der Stellkurve entlang, und die Klinke 20 schwenkt im Uhrzeigersinn, bis die Rastkanten 40 hinter die an dem Ende der Stellkurve vorgesehene Rastnase fallen. Der Entrastschlüssel 8 hakt sich damit in der Klinke 20 fest, die in der Stellung nach Fig. 2 so weit im Uhrzeigersinn verschwenkt ist, daß sie nicht mehr in den Wirkungsbereich der Einschuböffnungswand 12 eingreift. Das Servicegerät kann nun bei eingesteckten und in der Einstecklage gesicherten Entrastschlüsseln 8 aus der Armaturentafel bzw. aus dem Einbauausschnitt herausgezogen werden.

In Fig. 1 ist ein Sicherheitscodeschalter dargestellt, der mit einem Betätigungsstift 52 versehen ist. In der Hintergreifstellung der Klinke 20 nach Fig. 1 hat der Betätigungshebel 23 in der ausgezogen dargestellten Stellung keine Verbindung zu dem Betätigungsstift 52 des Sicherheitscodeschalters 51. Es ist in Fig. 1 aber gestrichelt angedeutet, daß der Betätigungshebel 23 bei einer Verstellung im Uhrzeigersinn mit dem Betätigungsstift 52 in Berührung kommt, um diesen zu verstellen. Bei der Darstellung nach Fig. 2 ist durch das Verschwenken der Klinke 20 im Uhrzeigersinn auch der Betätigungshebel 23 im Uhrzeigersinn verschwenkt, so daß er den Betätigungsstift 52 nach links geschoben hat. Der Sicherheitscodeschalter 51, der an einer Hauptschaltungsplatte des Gerätes angeordnet ist, hat damit entsprechend der vorgesehenen Schaltung den Sicherheitscode des Gerätes aktiviert. Dies ist besonders wichtig, da bei Geräten mit hohen Ausgangsleistungen die Sicherheitscodeaktivierung, die üblicherweise über den Spannungsabfall vorgenommen wird, etliche Sekunden beträgt aufgrund der Entladezeit der Kondensatoren. Wenn bereits beim Verschwenken der Klinke 20 der Sicherheitscodeschalter 51 den Sicherheitscode aktiviert, ist diese Zeit der Unsicherheit ausgeschaltet.

Wie bereits beschrieben, verrastet der Entrastschlüssel 8 am Ende seines Einschubweges hinter der Rastnase 43, die die Stellkurve in Einschubrichtung des Schlüssels 8 begrenzt. Der Schlüssel liegt mithin in Fig. 2 in einer Rastmulde 53. Nach der Entnahme des Gerätes aus der Einbauwand stecken damit beide Schlüssel 8 fest im Gerät; vor einem erneuten Einbau müssen sie aus dem Gerät entfernt werden.

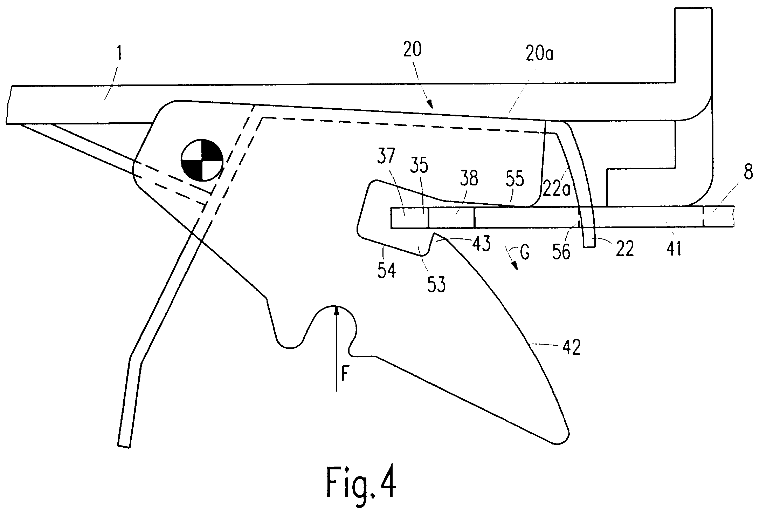

Die Entfernung der Schlüssel 8 erfolgt bei der Konfiguration mit der Überhuböffnung 41 im Schlüssel und mit der langen Rastnase 22 wie folgt:
Beide Klinken 20 befinden sich in der Auszugsposition gemäß Fig. 2. Beide Schlüssel 8 liegen mit ihrer Auszugkante 40 gegen die Rastnase 43. Die Klinken 20 werden nacheinander durch Drücken von Hand auf die Fläche 20a in eine Überhubposition gemäß Fig. 4 gebracht. Dabei tauchen die Rastnasen 22 in die Überhuböffnung 41 der Schlüssel 8 ein. Damit kommen die Auszugkanten 40 der Schlüssel an der Rastnase 43 frei, und die Schlüssel können bis zur Anlage von Kante 56 gegen die Unterseite 22a der Rastnase 22 gezogen werden. Nun werden die Klinken losgelassen und sind aus den Rastbereichen der Schlüssel heraus. Die Schlüssel können nun ganz aus dem Gerät herausgezogen werden. Die Klinken gehen dabei in ihre Ruheposition gemäß Fig. 1 zurück. Die Stellkurve 42 legt sich gegen Widerlager 31.

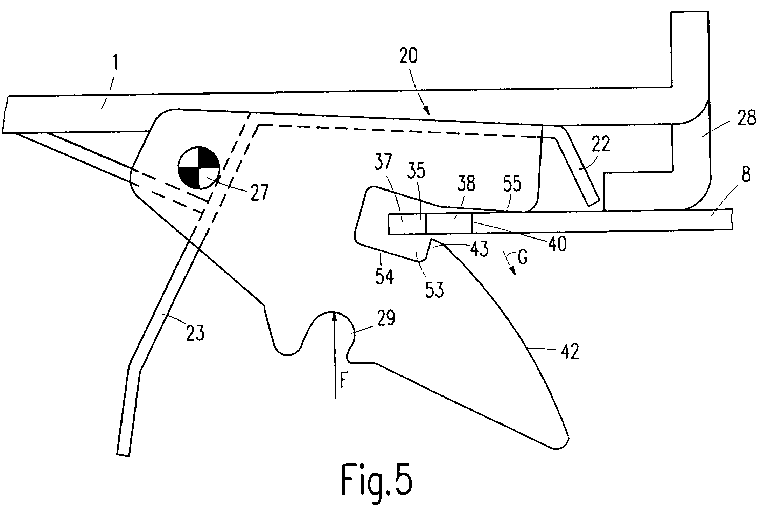

Bei der Konfiguration nach Fig. 5 fehlt im Schlüssel 8 die Überhuböffnung. Die Rastnase 22 ist steiler und kürzer gehalten. Die Schlüsselentnahme erfolgt dabei wie folgt: Ausgangsbasis ist wieder Fig. 2, jedoch mit kurzer, steiler Rastnase 22 nach Fig. 5. Das Gerät ist entnommen, die Schlüssel stecken im Gerät. Zwischen den Schlüsseln und den Rastnasen 22 ist um den Überhubbetrag Luft. Die Linken 20 werden nacheinander gegen den Schlüssel 8 gedrückt (siehe Fig. 5). Die Schlüssel 8 kommen mit ihren Auszugkanten 40 an den Rastnasen 43 frei und können aus dem Gerät herausgezogen werden. Diese Ausführung ist einfacher handhabbar, aber in bezug auf Einbautoleranzen in der Einbauwand kritischer.

## Patentansprüche

1. Einrichtung zum lösbaren Befestigen eines elektrischen Servicegerätes, wie eines Autoradios, CD- oder Kassettenspielers, Verstärkers, Verkehrsleitgerätes und dergl., in einem Einschubausschnitt (12) eines Einbauteiles (9), das die Armaturentafel eines Fahrzeuges sein kann, mit am Gerät angeordneten Gegenstützen (20), die in der eine Hintergreifstellung bildende Einbaulage, in der das Gerät von vorn in den Einbauausschnitt (10) angeschoben ist, das Einbauteil (9) von hinten hintergreifen und die zur Freigabe des Gerätes aus der Hintergreifstellung in eine Freigabestellung überführbar sind, dadurch gekennzeichnet, daß die Gegenstütze aus einer um eine Drehachse schwenkbaren Klinke (20) besteht, die in Richtung auf die Hintergreifstellung von einer Feder (30) belastet ist und die eine Stellkurve (42) aufweist, gegen die ein Entrastschlüssel (8) schiebbar ist, der beim Entlanglaufen an der Stellkurve (42) die Klinke (20) gegen die Federkraft in die Freigabestellung verschwenkt.

2. Einrichtung nach Anspruch 1, dadurch gekennzeichnet, daß an das in Einschieberichtung gelegene Ende der Stellkurve (42) an einer Mulde (53) endet, in die der die Stellkurve (42) abfahrende Entrastschlüssel (8) einfallen kann, um darin zu verrasten.

3. Einrichtung nach einem der Ansprüche 1 oder 2, dadurch gekennzeichnet, daß die Klinke (20) eine Rastnase (22) und der Entrastschlüssel (8) eine Sicherheitsöffnung (41) für das Eintauchen der Entrastnase (22) in die Sicherheitsöffnung (41) aufweist, wobei die Entrastnase (22) und die Sicherheitsöffnung (41) so zusammenwirken, daß der Entrastschlüssel (8) von der eintauchenden Rastnase (22) gegen ein Herausziehen gesichert ist, bis die Klinke (20) in die Hintergreifstellung fällt.

4. Einrichtung nach einem der Ansprüche 1 bis 3, dadurch gekennzeichnet, daß an der Klinke (20) ein Betätigungshebel (51) vorgesehen ist, der auf einen Sicherheitscodierschalter einwirkt, der bereits beim Verschwenken der Klinke (20) in die Sicherheitskodierstellung für die Elektronik des Gerätes überführbar ist.

5. Einrichtung nach einem der Ansprüche 1 bis 4, dadurch gekennzeichnet, daß die Feder (30) eine getrennte Stahlfeder ist, die sich in einem Lagerauge (29; 29a) der Klinke und in einem Gegenlager (29b₁, 29b₂) abstützt.

## Claims

1. A device for the detachable fastening of an electrical service appliance such as a car radio, a CD or cassette player, an amplifier, a traffic control unit, and the like, in an insertion opening wall (12) of a mounting frame (9), which may be the instrument panel of a motor vehicle, which appliance comprises countersupports (20) which grip behind the mounting frame (9) in a mounted state forming a back-locking position in which the appliance has been passed into the insertion opening (10) from the front, and which countersupports can be moved from the back-locking position into a release position for releasing the appliance, characterized in that the countersupport is formed by a latch (20) which is pivotable about a rotation shaft, which is loaded by a spring (30) in a direction towards the back-locking position, and which comprises a curved edge (42) against which an unlocking key (8) can be passed, which key when passing along the curved edge (42) pivots the latch (20) into the release position against the spring pressure.

2. A device as claimed in Claim 1, characterized in that the curved edge (42) in the insertion direction merges into a cavity (53) into which the unlocking key (8) which follows the curved edge (42) can enter so as to be held therein.

3. A device as claimed in any one of the Claims 1 and 2, characterized in that the latch (20) comprises a detent (22) and the unlocking key (8) comprises a security opening (41) for accommodating the detent (22), the detent (22) and the security opening (41) cooperating in such a manner that the unlocking key (8) is protected by the engaging detent (22) against pulling-out until the latch (20) drops into the back-locking position.

4. A device as claimed in any one of the Claims 1 to 3, characterized in that an operating lever (51) is provided at the latch (20), which lever acts on a security code switch which can already be moved into the security coding position for the electronics of the appliance during pivoting of the latch (20).

5. A device as claimed in any one of the Claims 1 to 4, characterized in that the spring (30) is a separate steel spring which is supported in a holder cavity (29,29a) of the latch and in an opposed holder (29b₁,29b₂).

## Revendications

1. Dispositif de fixation amovible d'un appareil de service électrique comme un autoradio, un lecteur de CD, un lecteur de cassettes, un amplificateur, un appareil de radioguidage, etc., dans une découpe d'encastrement (12) d'une pièce de montage (9) qui peut être le tableau de bord d'un véhicule avec des supports (20) disposés sur l'appareil qui saisissent par l'arrière la pièce de montage (9) dans la position de montage formant une position de saisie par l'arrière dans laquelle l'appareil est glissé par l'avant dans la découpe d'encastrement (10) et qui peuvent être déplacés en vue du déblocage de l'appareil de la position de saisie par l'arrière dans une position de déblocage caractérisé en ce que les supports se composent d'un loquet (20) qui peut pivoter autour d'un axe de rotation et qui est chargé par ressort (30) dans la direction de la position de saisie par l'arrière et présente une courbe de réglage (42) contre laquelle une clé de déblocage (8) peut glisser et fait alors pivoter le loquet (20) contre la force de ressort dans la position de déblocage lors du déplacement le long de la courbe de réglage (42).

2. Dispositif selon la revendication 1, caractérisé en ce que l'extrémité située dans la direction d'introduction de la courbe de réglage (42) s'évase en une cavité (53) dans laquelle la clé de déblocage (8) s'écartant de la courbe de réglage (42) peut s'introduire pour s'y enclencher.

3. Dispositif selon l'une des revendications 1 ou 2, caractérisé en ce que le loquet (20) présente un taquet d'enclenchement (22) et la clé de déblocage (8) une ouverture de sécurité (41) pour l'introduction du taquet de déblocage (22) dans l'ouverture de sécurité (41), le taquet de déblocage (22) et l'ouverture de sécurité (41) coopérant de telle manière que la clé de déblocage (8) soit bloquée contre l'extraction par le taquet d'enclenchement (22) à enfoncer jusqu'à ce que le loquet (20) parvienne dans la position de saisie par l'arrière.

4. Dispositif selon l'une des revendications 1 à 3, caractérisé en ce qu'un levier d'actionnement (51) qui agit sur un commutateur de codage de sécurité qui peut déjà passer en position de codage de sécurité pour l'électronique de l'appareil lors du pivotement du loquet (20) est prévu sur le loquet (20).

5. Dispositif selon l'une des revendications 1 à 4, caractérisé en ce que le ressort (30) est un ressort en acier séparé qui prend appui dans un oeillet de palier (29; 29a) du loquet et dans une butée (29b₁, 29b₂).
